# FASCICULE DE BREVET EUROPEEN

(11) **EP 3 671 857 B1**
(45) Date de publication et mention de la délivrance du brevet: **12.03.2025**
(21) Numéro de dépôt: 19218620.3
(22) Date de dépôt: 20.12.2019
(51) Int. Cl.: H01L 21/336, H01L 29/78

(54) **PROCÉDÉ DE RÉALISATION D'UN TRANSISTOR À SOURCE ET DRAIN SURÉLEVÉS**
HERSTELLUNGSVERFAHREN EINES TRANSISTORS MIT ERHÖHTER SOURCE UND DRAIN
METHOD FOR MANUFACTURING A TRANSISTOR WITH RAISED SOURCE AND DRAIN

(30) Priorité: 20.12.2018 FR 1873689
(43) Date de publication de la demande: 24.06.2020
(73) Titulaire: Commissariat à l'Energie Atomique et aux Energies Alternatives, 75015 Paris (FR)
(72) Inventeur: POSSEME, Nicolas, 38054 GRENOBLE (FR)
(74) Mandataire: Hautier IP

(56) Documents cités:
- EP-A1- 3 246 948
- US-A- 6 153 483

## Description

### DOMAINE TECHNIQUE

La présente invention concerne un procédé de réalisation d'espaceurs d'un transistor. Elle concerne plus particulièrement la réalisation d'espaceurs en forme de « L ». La présente invention trouvera pour application avantageuse la réalisation d'un transistor comprenant des source et drain surélevés et présentant des facettes latérales inclinées.

### ÉTAT DE LA TECHNIQUE

Les performances de commutation d'un transistor peuvent être améliorées en réduisant la résistance d'accès aux régions source et drain du transistor.

Une solution pour réduire cette résistance d'accès consiste à surélever les régions source et drain de part et d'autre de la grille du transistor, généralement par reprise d'épitaxie à partir du substrat. Une telle configuration de transistor comprenant une grille et des régions source et drain surélevées est appelée RSD, acronyme anglais de « Raised Source/Drain ».

La grille du transistor est isolée vis-à-vis des régions source et drain par des espaceurs, communément dénommés spacers d'après la terminologie anglo-saxonne. Les régions source et drain sont ici indifférenciées et référencées par un même acronyme « S/D ».

Les espaceurs couvrent les flancs latéraux de la grille et prennent appui sur le substrat au pied de la grille. Le document EP3246948A1 divulgue des exemples de réalisation d'espaceurs.

Dans une configuration RSD, la reprise d'épitaxie en bordure des espaceurs peut être influencée par la forme de ces espaceurs. Des espaceurs présentant des flancs sensiblement verticaux sur toute la hauteur de la grille favorisent la formation de S/D surélevés en couche, prenant appui contre les espaceurs. Cette configuration génère cependant une augmentation de la capacité de recouvrement entre les S/D et la grille, ce qui nuit aux performances de commutation du transistor.

Des espaceurs présentant une forme en L adossés aux flancs de la grille favorisent la formation de S/D surélevés facettés, présentant des flancs libres séparés des espaceurs. Cette dernière configuration permet d'augmenter la distance de séparation entre les S/D facettés et la grille. La capacité de recouvrement est ainsi diminuée. Les performances des transistors RSD sont ainsi améliorées.

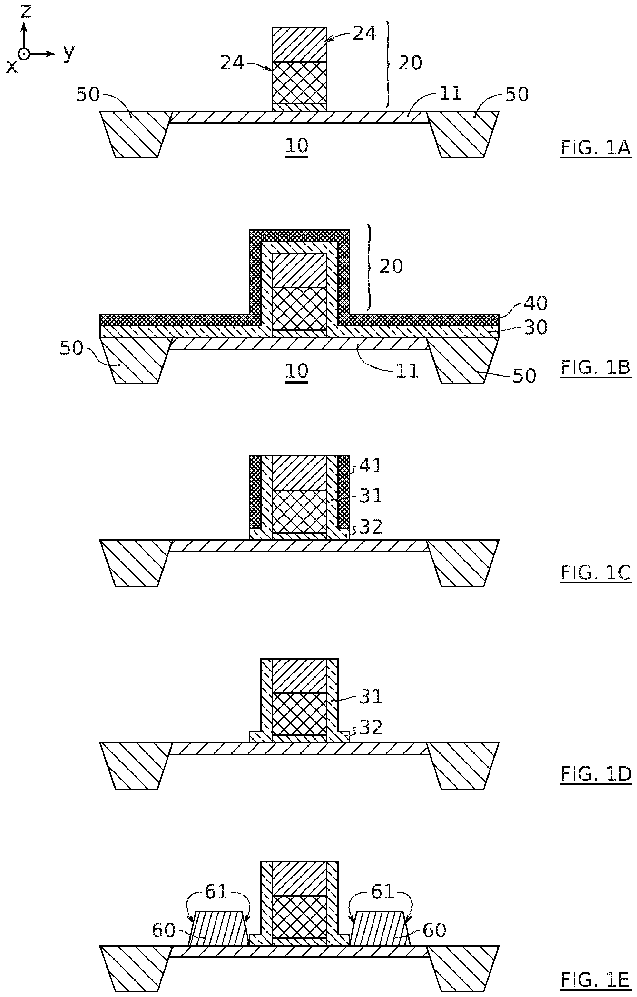

Les figures 1A à 1E illustrent un procédé connu pour former des espaceurs en forme de L et, *in fine,* des S/D facettés.

Ce procédé connu comprend les étapes de procédé suivantes :
Une première couche 30 en un premier matériau diélectrique est déposée de façon conforme sur la grille 20 et sur la couche active 11 semi conductrice.

Une deuxième couche 40 en un deuxième matériau différant du premier matériau est déposée de façon conforme sur la première couche 30 (fig. 1B).

Une gravure anisotrope des premier et deuxième matériaux, sélective vis-à-vis du matériau de la couche semi conductrice 11, est réalisée de sorte à retirer une partie sacrificielle des première et deuxième couches 30, 40 en regard de la couche active 11, en conservant des parties 31, 32, 41 des première et deuxième couches 30, 40 situées sur les flancs 24 de la grille 20 (fig. 1C).

Une gravure isotrope du deuxième matériau, sélective vis-à-vis du premier matériau, est réalisée de sorte à retirer la partie 41 de la deuxième couche 40 en conservant les parties 31, 32, de la première couche 30.

Les parties 31, 32, de la première couche 30 forment ainsi un espaceur en forme de L sur chacun des flancs 24 de la grille 20 (fig. 1D).

Les S/D 60 formés par reprise d'épitaxie présentent alors des flancs facettés 61 (fig. 1E).

Un inconvénient de cette solution est que la gravure anisotrope des premier et deuxième matériaux induit une consommation de la couche active 11 par surgravure. Cette consommation de la couche active 11 a pour inconvénient de favoriser l'apparition de défauts cristallins dans les S/D lors de la reprise d'épitaxie.

Un autre inconvénient de cette solution est que les différentes vitesses de gravure des premier et deuxième matériaux induisent, à l'échelle de la plaque (habituellement désignée par le vocable anglais wafer) portant les transistors, une inhomogénéité dans la consommation de la couche active, en particulier dans le cas d'une grande densité d'intégration des transistors.

La présente invention a pour objectif de pallier en partie au moins les inconvénients mentionnés ci-dessus.

Un objet de la présente invention est de proposer un procédé de formation d'espaceurs en forme de L limitant la consommation de la couche active.

Un autre objet de l'invention est de proposer un procédé de réalisation d'un transistor comprenant des S/D surélevés facettés présentant une qualité cristalline améliorée.

### RÉSUMÉ

Pour atteindre cet objectif, la présente invention prévoit un procédé de réalisation sur une couche active semi-conductrice d'au moins un transistor comprenant une grille, une source et un drain, lesdits source et drain étant surélevés par rapport à la couche active et présentant des facettes latérales inclinées par rapport à une direction normale à la couche active, référencée direction Z, le procédé comprenant au moins les étapes suivantes :
- Fournir un empilement comprenant la couche active s'étendant principalement selon un plan principal et un motif de grille, le motif de grille présentant des flancs latéraux s'étendant perpendiculairement à la couche active ;
- Déposer sur le motif de grille et la couche active une couche en un matériau diélectrique présentant une épaisseur e₃₀ et comprenant des portions, dites portions latérales, recouvrant les flancs latéraux, et des portions, dites portions basales, s'étendant principalement parallèlement audit plan principal, les portions latérales étant sensiblement normales aux portions basales ;
- Réaliser une modification isotrope de ladite couche sur une épaisseur e₃₀₁, de façon à obtenir une première portion de couche modifiée comprenant un matériau diélectrique modifié, avec e₃₀₁ < e₃₀,
- Avant ou après l'étape de réalisation d'une modification isotrope :
   - Réaliser une modification anisotrope de ladite couche sur une épaisseur e₃₀, selon la direction normale à la couche active, de façon à obtenir des deuxièmes portions de couche modifiée comprenant le matériau diélectrique modifié en conservant des portions de couche non modifiée sur les flancs latéraux du motif de grille et sur la couche active au pied du motif de grille, à l'aplomb des portions latérales couvrant les flancs du motif de grille,
   - Retirer les première et deuxièmes portions modifiées en conservant les portions de couche non modifiée, par gravure sélective du matériau diélectrique modifié vis-à-vis du matériau diélectrique non modifié, de façon à former des espaceurs présentant une forme de L.
La première portion de couche modifiée est conservée à l'issue de la modification isotrope et les deuxièmes portions de couche modifiée sont conservées à l'issue de la modification anisotrope. La modification isotrope n'est pas une gravure du matériau de la couche en un matériau diélectrique. C'est une étape distincte et préalable au retrait de la première portion modifiée. La modification anisotrope n'est pas non plus une gravure du matériau de la couche en un matériau diélectrique. C'est une étape distincte et préalable au retrait des deuxièmes portions modifiées.

Le retrait des première et deuxième portions modifiées est effectué après les modifications isotrope et anisotrope.

De manière optionnelle on effectue ensuite une étape consistant à épitaxier les source et drain de façon à obtenir des source et drain surélevés par rapport à la couche active et présentant des facettes latérales inclinées par rapport à la direction Z. Cette épitaxie s'effectue à partir de la couche active et en bordure desdits espaceurs en forme de L, de préférence au contact de ces derniers.

Ainsi, le procédé selon l'invention permet de réaliser sur les flancs du motif de grille des espaceurs en forme de L à partir d'un seul dépôt de couche en un matériau diélectrique.

La gravure du matériau modifié permet également en une seule étape de :
- former les espaceurs en forme de L et,
- exposer la couche active en vue de la croissance des source et drain par épitaxie.

Le procédé selon l'invention nécessite donc moins d'étapes de dépôt et de gravure qu'un procédé classique de formation d'espaceurs en forme de L tel que présenté plus haut.

En outre, la gravure du matériau modifié est avantageusement isotrope.

Cette gravure isotrope du seul matériau modifié est plus facile à contrôler qu'une gravure anisotrope d'un empilement de deux matériaux, telle que mise en œuvre dans le procédé classique illustré aux figures 1A à 1E.

En particulier, une telle gravure isotrope peut être précisément arrêtée au niveau de la surface de la couche active, en limitant voire en éliminant la consommation de cette dernière.

L'étape suivante de croissance des S/D facettés par reprise d'épitaxie bénéficie dès lors d'une germination améliorée sur la surface de la couche active semi conductrice non dégradée ou peu dégradée.

La qualité cristalline des S/D facettés est améliorée.

Les modifications isotropes et anisotropes du procédé selon la présente invention peuvent être avantageusement réalisées sans ordre particulier.

Ces modifications isotropes et anisotropes peuvent également être avantageusement réalisées au sein d'un même bâti, par exemple dans un réacteur plasma ou dans un implanteur classique.

Les autres objets, caractéristiques et avantages de la présente invention apparaîtront à l'examen de la description suivante et des dessins d'accompagnement. Il est entendu que d'autres avantages peuvent être incorporés.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1E illustrent des étapes d'un procédé de réalisation de S/D facettés selon l'art antérieur.
Les figures 2A à 2E illustrent des étapes d'un mode de réalisation du procédé de réalisation de S/D facettés selon l'invention.
La figure 3 illustre, de manière simplifiée sous forme d'un ordinogramme les étapes de deux modes de réalisation du procédé de réalisation de S/D facettés selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et portions modifiées ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
- Selon un mode de réalisation, le dépôt de la couche en un matériau diélectrique est un dépôt conforme, de sorte que les portions latérales et basales présentent sensiblement la même épaisseur e₃₀.
- Selon un mode de réalisation, la modification isotrope est réalisée avant la modification anisotrope. Alternativement, la modification isotrope est réalisée après la modification anisotrope.
- Selon un mode de réalisation, la couche en un matériau diélectrique est homogène et comprend uniquement ledit matériau diélectrique. En particulier, cette couche ne comprend pas une pluralité de couches présentant différentes natures chimiques, avant les modifications isotrope et nisotrope.
- Selon un mode de réalisation, le matériau diélectrique est choisi parmi le SiN, le SiCO, le SiC, le SiCN, le SiOCN, le SiCBN, le SiOCH, et le SiO2.
- Selon un mode de réalisation, l'épaisseur e₃₀ est comprise entre 5 nm et 30 nm, de préférence entre 7 nm et 12 nm, et l'épaisseur e₃₀₁ est comprise entre 3 nm et 6 nm.
- Selon un mode de réalisation, l'e₃₀₀ est l'épaisseur de la couche diélectrique qui demeure non modifiée après l'étape d'implantation isotrope, avec e₃₀₀ telle que e₃₀₀ = e₃₀ - e₃₀₁ et e₃₀₀ ≥ 2nm, de préférence e₃₀₀ ≥ 3 nm et de préférence e₃₀₀ ≥ 5nm.
- Selon un mode de réalisation, l'épaisseur e₃₀₀ est telle que e₃₀₀ ≤ e₃₀ - 3 nm.
- Selon un mode de réalisation, les modifications isotrope et anisotrope sont réalisées par implantation d'ions à partir d'un faisceau d'ions d'au moins une espèce parmi l'argon (Ar), le fluor (F), l'oxygène (O) et l'hydrogène (H).
- Selon un mode de réalisation, la modification isotrope est réalisée en faisant varier un angle d'inclinaison du faisceau d'ions lors de l'implantation, ledit angle d'inclinaison étant compris entre -30° et +30° par rapport à la direction Z.
- Selon un mode de réalisation, la modification anisotrope est réalisée pour un faisceau d'ions principalement dirigé selon la direction Z lors de l'implantation.
- Selon un mode de réalisation, les modifications isotropes et anisotropes sont réalisées par implantation d'ions provenant d'un plasma, à partir d'au moins une espèce parmi H2, He, HBr, et NH3.
- Selon un mode de réalisation, la modification isotrope est réalisée en maintenant une pression supérieure à 100 milli Torr lors de l'implantation par plasma.
- Selon un mode de réalisation, la modification anisotrope est réalisée en maintenant une pression inférieure à 100 milli Torr lors de l'implantation par plasma.
- Selon un mode de réalisation, la gravure sélective du matériau diélectrique modifié vis-à-vis du matériau diélectrique est une gravure humide à l'aide d'une solution à base d'acide fluorhydrique (HF) ou à l'aide d'une solution à base d'acide phosphorique (H3PO4).
- Selon un mode de réalisation, la gravure sélective du matériau diélectrique modifié vis-à-vis du matériau diélectrique est une gravure sèche, de préférence effectuée dans un plasma formé à partir de trifluorure d'azote (NF3) et d'ammoniac (NH3) et dans lequel la gravure sèche comprend une étape de gravure consistant en la formation de sels solides suivie d'une étape de sublimation desdites espèces solides.
- Selon un mode de réalisation, la gravure sélective du matériau diélectrique modifié vis-à-vis du matériau diélectrique comprend :
   - une gravure sèche réalisée par mise en présence des première et deuxièmes portions modifiées avec un mélange gazeux, de préférence uniquement gazeux, comprenant au moins un premier composant à base d'acide fluorhydrique (HF), l'acide fluorhydrique transformant en résidus non-volatiles à température ambiante lesdites première et deuxièmes portions modifiées,
   - après la gravure sèche, un retrait des résidus non-volatiles à température ambiante par un nettoyage humide ou par un recuit thermique de sublimation.
- Selon un mode de réalisation, la modification isotrope est réalisée par implantation isotrope d'ions dans la couche en matériau diélectrique à l'aide d'un implanteur et en modifiant une direction de bombardement au cours de l'implantation ou par implantation isotrope d'ions provenant d'un plasma comprenant de préférence des ions hélium ou des ions à base d'hydrogène, à une pression de préférence supérieure à 100 milli Torr.
- Selon un mode de réalisation, la modification anisotrope est réalisée par implantation anisotrope d'ions dans la couche en matériau diélectrique à l'aide d'un implanteur et en conservant une direction de bombardement sensiblement constante au cours de l'implantation, cette direction étant sensiblement parallèle aux flancs latéraux du motif de grille.
- Selon un mode de réalisation, la modification anisotrope est réalisée par implantation anisotrope d'ions provenant d'un plasma comprenant de préférence des ions hélium ou des ions à base d'hydrogène, à une pression de préférence inférieure à 100 milli Torr.
- Selon un mode de réalisation le motif de grille est destiné à former une grille pour le transistor. Le motif de grille est alors fonctionnel. Il s'agit alors d'un procédé que l'on peut qualifier de « gate first », c'est-à-dire dans lequel la grille est réalisée au préalable.
- Selon un autre mode de réalisation, le motif de grille est destiné à être retiré, après avoir formé les espaceurs, pour ensuite être remplacé par un motif fonctionnel de grille. Le motif de grille est alors sacrificiel. Il s'agit alors d'un procédé que l'on peut qualifier de « gate last», c'est-à-dire dans lequel la grille est réalisée dans un second temps.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, une couche à base de silicium s'entend par exemple d'une couche Si, Si dopé n, Si dopé p, SiGe. Une couche à base de germanium s'entend par exemple d'une couche Ge, Ge dopé n, Ge dopé p, SiGe

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7.

Les matériaux diélectriques envisagés dans le cadre la présente invention sont, de manière non limitative, le SiN, le SiCO, le SiC, le SiCN, le SiOCN, le SiCBN, le SiOCH, le SiO2.

Le matériau diélectrique modifié est réputé différent du matériau diélectrique non modifié.

Les termes « matériau diélectrique », « matériau diélectrique initial », « matériau diélectrique non modifié » sont synonymes.

Il est précisé que, dans le cadre de la présente invention, l'épaisseur d'une couche ou du substrat se mesure selon une direction perpendiculaire à la surface selon laquelle cette couche ou ce substrat présente son extension maximale.

Dans la présente invention, le substrat et la couche active s'étendent selon un plan principal. On qualifie de direction normale au substrat ou à la couche active, une direction perpendiculaire à ce plan principal.

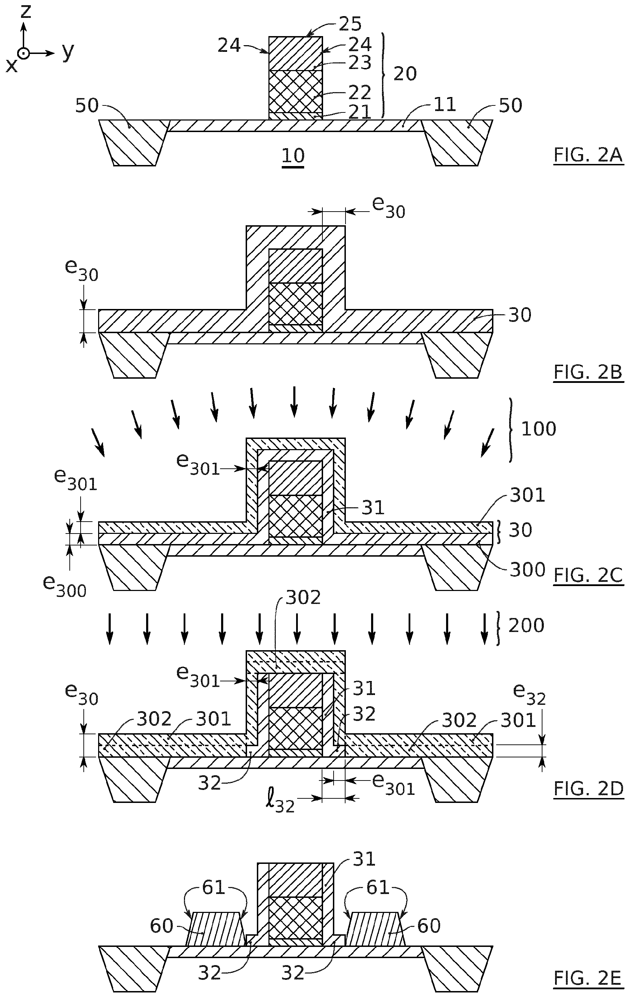

Sur les figures, ce plan correspond au plan XY du repère orthogonal XYZ illustré en figure 2A. La direction normale est parallèle à l'axe Z de ce repère.

Sur les figures, l'épaisseur est prise selon la verticale dans les zones qui s'étendent principalement à l'horizontale, telles que les portions basales.

En revanche, l'épaisseur est prise selon l'horizontale dans les zones qui s'étendent principalement à la verticale, telles que les portions latérales. Ainsi, l'épaisseur des espaceurs qui recouvrent des flancs verticaux d'une grille ou d'un motif de grille sera mesurée selon la direction horizontale sur les figures.

De même lorsqu'on indique qu'un élément est situé à l'aplomb ou au droit d'un autre élément, cela signifie que ces deux éléments sont situés tous deux sur une même ligne perpendiculaire au plan principal, soit sur une même ligne orientée verticalement sur les figures.

Dans la présente invention, des espaceurs en forme de « L » sont formés. La forme en « L » correspond à une forme présentant une portion longitudinale orientée selon la verticale sur les figures, et un pied sensiblement transverse à cette portion longitudinale, situé à une extrémité de cette portion longitudinale. La forme en « L » comprend également sa forme symétrique selon l'axe Z.

Le pied de la forme en « L » peut présenter un biseau, selon le mode de réalisation de l'invention mis en œuvre.

Cette forme en « L » est ici spécifiquement recherchée, pour les avantages qu'elles confèrent et qui sont rappelés en introduction à la présente invention.

La forme en « L » volontairement réalisée dans la présente invention doit être distinguée d'une forme en « L » involontaire issue d'une gravure mal maîtrisée par exemple. Une telle forme en « L » involontaire ne saurait être qu'une divulgation fortuite.

Les figures 2A à 2E illustrent un mode de réalisation du procédé selon l'invention.

Selon ce mode de réalisation, une structure initiale illustrée en figure 2A est fournie.

Cette structure peut typiquement comprendre un substrat 10 surmonté d'une couche active 11 semi-conductrice à base de silicium ou de germanium.

Le substrat 10 peut comprendre un support surmonté par une couche isolante électriquement, typiquement une couche d'oxyde.

Le support, la couche isolante et la couche active 11 peuvent former un substrat élaboré de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator).

Dans la suite de la description, la couche active 11, le substrat 10 et le substrat élaboré pourront être indifféremment désignés « substrat ».

La couche active 11 est surmontée d'un empilement de grille 20 ou motif de grille 20.

De manière classique, l'empilement de grille 20 peut présenter successivement les couches suivantes disposées à partir de la couche active 11: une couche d'oxyde d'interface 21 à haute constante diélectrique, dite couche « high k » (par exemple à base d'oxyde d'hafnium), une grille polysilicium 22 et un masque dur 23.

L'empilement de grille 20 présente typiquement une hauteur selon Z de plusieurs dizaines de nanomètres à plusieurs centaines de nanomètres.

Dans la suite de la description, et par souci de concision, l'empilement de grille ou le motif de grille sera désigné par la suite grille 20.

L'invention couvre également un mode de réalisation alternatif pour lequel le motif de grille 20 est un motif sacrificiel destiné à être retiré après réalisation des espaceurs, puis à être remplacé par un autre empilement de grille formant une grille 20. Un tel procédé est couramment qualifié de « gate last » selon la terminologie anglo-saxonne. La grille 20 dans la suite désigne donc indifféremment un empilement de grille de type « gate first » (la grille est conservée à l'issue de la réalisation des espaceurs) ou de type « gate last » (la grille est remplacée à l'issue de la réalisation des espaceurs).

Pour former un transistor isolé vis-à-vis d'un transistor ou d'un composant adjacent, des caissons d'isolation 50 communément appelés STI (de l'acronyme anglais « Shallow Trench Isolation » signifiant tranchées d'isolation superficielles) peuvent être formés.

Les étapes de formation des espaceurs en forme de L sur cette structure initiale, et par suite, la réalisation des source et drain surélevés permettant d'obtenir un transistor RSD à partir de cette structure initiale, sont décrites ci-après en référence à un premier mode de réalisation.

Tel qu'illustré à la figure 2B, une couche 30 en un matériau diélectrique est déposée sur la grille 20 et sur la couche active 11 semi conductrice, de préférence de façon conforme.

Cette couche 30 comprend une portion latérale 30L sur chacun des flancs latéraux 24 de la grille 20, des portions basales 30B en surface du substrat de part et d'autre de la grille 20, au contact de la couche active 11, et une portion basale 30B au sommet 25 de la grille 20. Les portions latérales 30L s'étendent selon des plans perpendiculaires au plan XY et les portions basales 30B s'étendent selon des plans parallèles au plan XY.

La couche 30 présente une épaisseur e₃₀ comprise entre 5 nm et 30 nm, de préférence entre 7 nm et 12 nm.

Comme illustré à la figure 2C, une première étape de modification isotrope est effectuée.

La modification isotrope comprend notamment une implantation 100 d'espèces, en particulier des ions, dans une première portion 301 de la couche 30, superficielle, de façon à modifier le matériau diélectrique initial.

Cette modification isotrope forme une portion 301 continue au sein de la couche 30 et qui s'étend depuis la surface de cette couche 30. Cette portion 301 présente une épaisseur e₃₀₁ constante le long de la couche 30, à partir de la surface de la couche 30.

La portion 301 s'étend à la fois selon le plan principal du substrat et le long des flancs latéraux de la grille 20. La portion 301 comprend le matériau diélectrique modifié.

La modification isotrope est configurée pour obtenir une épaisseur e₃₀₁ de matériau diélectrique modifié telle que e₃₀₁ est strictement inférieure à e₃₀.

L'épaisseur e₃₀₁ ≥ 2nm et de préférence e₃₀₁ ≥ 5nm. L'épaisseur e₃₀₁ est telle que e₃₀₁ ≤ e₃₀ - 3 nm. De préférence e₃₀₁ est comprise entre 2 nm et 6 nm.

Différents modes de réalisation de la modification isotrope seront décrits en détail dans la suite.

A l'issue de l'étape de modification isotrope, une partie 300 de la couche 30 initiale reste non modifiée. Cette partie 300 présente une épaisseur e₃₀₀ = e₃₀ - e₃₀₁.

Comme illustré à la figure 2D, une deuxième étape de modification, cette fois ci anisotrope, est effectuée.

La modification anisotrope comprend notamment une implantation 200 d'espèces, en particulier des ions, dans des deuxièmes portions 302 de la couche 30, de façon à modifier le matériau diélectrique initial. Cette implantation anisotrope est effectuée selon une direction principale de bombardement des ions. Cette direction principale est parallèle au plan dans lesquels les flancs 24 de la grille 20 s'étendent principalement. Dans cet exemple, cette direction principale est perpendiculaire au plan XY du substrat. Cette direction correspond donc à l'axe Z.

Cette modification anisotrope forme au sein de la couche 30 des portions 302 discontinues sur l'ensemble du substrat. Ces portions 302 présentent une épaisseur e₃₀ au niveau des portions basales 30B de la couche 30.

Les portions 302 s'étendent uniquement selon le plan principal du substrat. Les portions 302 comprennent le matériau diélectrique modifié. La modification anisotrope est configurée pour modifier le matériau diélectrique sur toute une épaisseur de la couche 30.

Les portions 302 sont en partie superposées à la portion 301.

Différents modes de réalisation de la modification anisotrope seront décrits en détail dans la suite.

A l'issue de ces étapes de modification isotrope et de modification anisotrope, des portions 31, 32 de la couche 30 initiale sont conservées. Ces portions 31, 32 comprennent le matériau diélectrique initial, c'est-à-dire non modifié.

Les portions 31 s'étendent le long des flancs latéraux 24 de la grille 20. Ces portions 31 sont disposées directement au contact de la grille. Elles s'étendent sur toute la hauteur de la grille 20. Elles présentent l'épaisseur e₃₀₀.

Elles forment avantageusement la partie longitudinale du L.

Les portions 32 s'étendent le long de la couche active 11. Elles sont de préférence directement au contact de la couche active 11. Elles présentent une épaisseur e₃₂ selon z, telle que e₃₂ = e₃₀ - e₃₀₁. Elles présentent une dimension l₃₂ selon y, sensiblement égale à e30.

Elles forment avantageusement le pied du L.

On remarquera que l'extrémité distale du pied du L est formée par une portion située à l'aplomb des portions modifiées 301 situées sur les flancs 24 de la grille 20. La dimension de cette extrémité distale du pied du L selon l'axe Y est égale à l'épaisseur e₃₀₁. Cette dimension est directement conditionnée par l'épaisseur e₃₀₁.

En effet, selon ce mode de réalisation comprenant une modification isotrope effectuée avant la modification anisotrope, ce sont ces portions modifiées 301 situées sur les flancs 24 de la grille 20 qui masquent l'extrémité distale du pied du L lors de la modification isotrope et empêchent leur modification.

Selon un autre mode de réalisation comprenant une modification anisotrope effectuée avant la modification isotrope, l'extrémité distale du pied est masquée par la portion latérale 30L lors de la modification anisotrope. Elle est ensuite formée lors de la modification anisotrope sur l'épaisseur e₃₀₁.

On notera que lors de cette implantation anisotrope, il se peut que des ions soient implantés latéralement dans la couche diélectrique 30 recouvrant les flancs 24 du motif de grille 20. Cette implantation latérale, qui ne s'effectue donc pas selon la direction privilégiée de l'implantation anisotrope, et par exemple due à une certaine défection des ions. Cette implantation latérale s'effectue sur une profondeur inférieure ou égale à 2 nm, cette profondeur étant mesurée selon la direction horizontale sur la figure 2D.

De manière avantageuse, cette implantation latérale involontaire n'impacte pas négativement le contrôle dimensionnel des espaceurs 31 qui seront formés. En effet, cette profondeur d'implantation latérale reste inférieure à la profondeur e₃₀₁ modifiée lors de l'étape d'implantation isotrope. Cet effet technique est procuré quel que soit l'ordre dans lequel les étapes de modification isotrope et anisotrope sont effectuées.

Une gravure des portions 301, 302 est ensuite effectuée, de façon à exposer les portions 31, 32.

Cette gravure est une gravure sélective du matériau diélectrique modifié vis-à-vis du matériau diélectrique non modifié, et vis-à-vis du substrat.

Elle est de préférence isotrope.

Différentes solutions de gravure adaptées à cette étape de gravure seront détaillées dans la suite.

A l'issue de cette étape de gravure, les espaceurs en forme de L sont avantageusement formés sur chacun des flancs latéraux 24 de la grille 20 (fig. 2E).

Les S/D 60 sont alors formés par reprise d'épitaxie en bordure des espaceurs en forme de L. Les S/D 60 ainsi formés présentent avantageusement des flancs facettés 61 (fig. 2E).

Dans le mode de réalisation décrit ci-dessus en référence aux figures 2A à 2E, la modification isotrope est effectuée avant la modification anisotrope.

Néanmoins, selon un autre mode de réalisation couvert par les revendications, la modification isotrope est effectuée après la modification anisotrope. Il s'ensuit que les étapes illustrées aux figures 2C et 2D sont interverties.

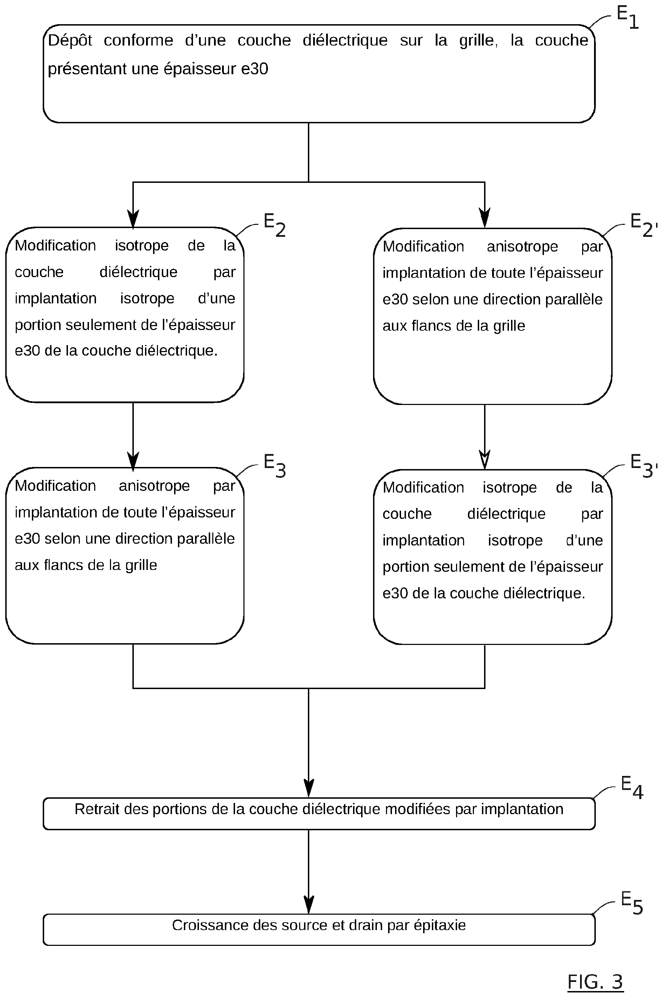

La figure 3 illustre de manière simplifiée sous forme d'ordinogramme les étapes principales de deux modes de réalisation du procédé de réalisation de S/D facettés selon l'invention.

L'étape E1 concerne le dépôt conforme de la couche 30 d'épaisseur e₃₀ sur la grille 20.

L'étape E2 concerne la modification isotrope de la couche 30 par implantation isotrope 100 pour former la portion modifiée 301 à la surface de la couche 30.

L'étape E3 concerne la modification anisotrope par implantation anisotrope 200 de toute l'épaisseur e₃₀ de la couche 30.

Cette figure 3 fait également apparaître le mode de réalisation dans lequel la modification anisotrope est effectuée avant la modification isotrope. Ce mode de réalisation correspond aux étapes E2' et E3'.

À l'issue de ces étapes E2 puis E3 ou E2' puis E3', la structure présente donc des portions 31, 32 non modifiées de la couche 30 et qui forment des L sur les flancs 24 de la grille 20.

L'étape E4 correspond au retrait des portions modifiées 301, 302 sélectivement aux portions non modifiées 31, 32 de la couche 30. À l'issue de cette étape E4, les espaceurs en forme de L sont réalisés.

L'étape E5 correspond à la croissance des source 60 et drain 60 par épitaxie, qui, grâce au pied des espaceurs en forme de L, permet de faire croître de manière inclinée les facettes 61 des source 60 et drain 60.

Différents modes de réalisation des étapes mentionnées ci-dessus vont maintenant être décrits en détail.

### Modification isotrope 100

Comme mentionné ci-dessus en référence à la figure 2C, la modification isotrope d'une portion 301 de la couche diélectrique 30 est effectuée par une implantation isotrope 100 d'ions.

Cette portion 301 continue est obtenue est assimilable à une couche.

L'implantation 100 permet ainsi de définir dans la couche diélectrique 30 :
- une couche modifiée 301 dont l'épaisseur e₃₀₁ correspond à la profondeur d'implantation de la couche diélectrique 30,
- une couche non modifiée 300, surmontée par la couche modifiée 301. L'épaisseur e₃₀₀ de cette couche non modifiée correspond à l'épaisseur e₃₀ initiale de la couche diélectrique 30 moins l'épaisseur e₃₀₁ de la couche modifiée 301.
- Typiquement, e₃₀₁ ≥ 2 nm, et de préférence e₃₀₁ ≥ 5 nm. Plus généralement, 2 nm ≤ e₃₀₁ ≤ 10 nm.
- Par exemple, si 5 nm < e₃₀ < 30 nm, alors 2 nm < e₃₀₁ < 10 nm.

Selon un premier exemple, l'implantation isotrope 100 peut être réalisée dans un implanteur classique (habituellement désigné par « beamline »), c'est-à-dire avec une implantation par faisceau d'ions.

Un avantage procuré par l'utilisation d'un implanteur est la possibilité de modifier les portions latérales 30L de la couche diélectrique 30 sur les flancs latéraux 24 de la grille 20 en bombardant selon plusieurs inclinaisons (tilt) de direction d'implantation.

Pour ce type d'implantation, on aura par exemple recours aux espèces suivantes pour modifier la couche diélectrique 30: argon (Ar), fluor (F), oxygène (O) ou hydrogène (H). On adaptera l'angle d'inclinaison de l'implantation ainsi que l'énergie des ions en fonction de la densité et de la forme des motifs formés par les empilements de grille 20, ainsi qu'en fonction de l'épaisseur de la couche diélectrique 30.

Typiquement, la dose implantée par faisceau d'ions est supérieure à 1^{E}13 atomes par centimètres carrés (at/cm²). Elle sera plus généralement comprise entre 1^{E}14 et 1^{E}17 at/cm².

Ces conditions d'implantation sont par exemple déterminées par simulation en utilisant des outils de simulation de type SRIM (stopping and range of ions matter) ou TRIM (transport simulation of ions in matter). Ces outils de simulation peuvent également être utilisés pour déterminer les conditions d'implantation pour les implantations par plasma qui seront détaillées ci-dessous.

Selon un deuxième exemple, privilégié, l'implantation isotrope 100 peut être réalisée dans un équipement de gravure plasma. Dans ce cas, on pourra utiliser un réacteur plasma à couplage capacitif (CCP) ou un réacteur plasma à couplage inductif (ICP), ou un plasma par immersion.

L'implantation d'ions par plasma est une solution avantageuse, notamment puisqu'elle permet de contrôler avec précision la profondeur implantée afin :
- d'implanter et donc de modifier une partie seulement de l'épaisseur de la couche diélectrique 30 ;
- de ne pas implanter les couches sous-jacentes, en particulier la couche active 11 et les différentes couches de l'empilement de grille 20.

Par ailleurs, l'intérêt du plasma est que l'on a une modification chimique notamment par implantation H, qui rend le retrait de la couche modifiée plus facile.

Selon un exemple de réalisation, cette modification comprend l'implantation d'ions à base d'hydrogène (H, H⁺, H₂⁺, H₃⁺, etc....).

Selon un autre mode de réalisation les ions implantés sont des ions d'hélium (He) ou un mélange d'ions d'hélium et d'hydrogène (H/He).

Ces ions peuvent provenir par exemple des gaz suivants introduits dans le réacteur : H₂, HBr ; NH₃.

Afin d'obtenir une modification isotrope 100 par implantation par plasma on peut jouer sur plusieurs paramètres :
- la pression. De préférence elle est supérieure à 100 milli Torr. Cela permet d'avoir une déflection des ions pour atteindre les flancs latéraux 24 des empilements de grille 20.
- La température. Elle est de préférence inférieure à 100°C ce qui permet de modifier plus efficacement la couche diélectrique 30. Il a été constaté qu'au-delà de 100°C les ions H implantés désorbent ce qui amoindrit l'effet de modification escompté.
- Les espèces implantées. Les ions à base d'H et He permettent une implantation de la couche diélectrique 30 sans pulvérisation de cette dernière et sans dépôt à la surface de cette dernière
- On peut également pulser la tension de polarisation (bias) et/ou la source de manière à accentuer l'effet isotrope.

En plus des avantages mentionnés ci-dessus, l'implantation par plasma a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs très fines typiquement de quelques nanomètres. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

A l'issue de cette étape d'implantation isotrope 100, une portion 301 seulement de la couche diélectrique 30 est modifiée.

La couche modifiée 301 présente une épaisseur e₃₀₁ constante sur toute sa surface, l'épaisseur de cette couche 301 étant mesurée, en chaque point de cette couche 301, selon une direction perpendiculaire à la tangente en ce point.

### Modification anisotrope 200

Comme mentionné ci-dessus en référence à la figure 2D, l'étape suivant ou précédant l'étape de modification isotrope 100, consiste à modifier de manière anisotrope la couche 30, sur toute l'épaisseur e₃₀ et selon une direction parallèle aux flancs latéraux 24 de l'empilement de grille 20.

Cette modification anisotrope 200 permet ainsi de modifier les portions basales 30B de la couche 30 sur toute l'épaisseur e₃₀.

En revanche, cette modification ne modifie pas les portions 31, 32 situées sur les flancs 24 et au pied de l'empilement de grille 20, ces portions étant masquées par la portion basale 30B située au sommet 25 de l'empilement de grille 20.

Cette modification anisotrope 200 est effectuée par implantation anisotrope d'ions sur toute l'épaisseur e₃₀ avec arrêt à l'interface entre la couche diélectrique 30 et les couches 11, 50 qui lui sont sous-jacentes.

Comme pour la modification isotrope 100, cette modification anisotrope 200 peut être effectuée dans un implanteur ou à partir d'un plasma. Ces deux modes de réalisation et leurs variantes sont détaillés ci-dessous:
Selon un premier exemple, l'implantation anisotrope peut être réalisée dans un implanteur classique.

Contrairement à l'implantation isotrope, l'angle d'implantation reste constant tout au long de l'implantation. Cette inclinaison est parallèle aux flancs 24 de la grille 20 recouverts de la couche diélectrique 30.

Les espèces implantées peuvent être de l'argon (Ar), du fluor (F), de l'oxygène (O) ou de l'hydrogène (H). Ces espèces permettent une implantation précise afin de stopper l'implantation aux interfaces entre la couche diélectrique 30 et les couches 11, 50 qui lui sont sous-jacentes d'une part, et entre la couche diélectrique 30 et l'empilement de grille 20 (interface 25) d'autre part.

A l'étape suivante, les portions modifiées 301, 302 de la couche diélectrique 30 pourront ainsi être retirées par gravure sèche et de manière sélective vis-à-vis de la couche active 11 et de l'empilement de grille 20.

Selon un deuxième exemple, privilégié, l'implantation anisotrope 200 peut être réalisée dans un équipement de gravure plasma. Dans ce cas, on pourra utiliser un réacteur plasma à couplage capacitif (CCP) ou un réacteur plasma à couplage inductif (ICP), ou un plasma par immersion.

L'implantation d'ions par plasma est une solution avantageuse, notamment puisqu'elle permet de contrôler avec précision la profondeur implantée afin :
- d'implanter et donc de modifier toute l'épaisseur de la couche diélectrique 30 ;
- de ne pas implanter les couches sous-jacentes, en particulier la couche active 11 et les différentes couches de l'empilement de grille 20.

Les autres avantages mentionnés dans le cas de l'implantation isotrope 100 par plasma sont également valables pour l'implantation anisotrope 200 par plasma.

On réglera les paramètres suivants afin d'obtenir une implantation anisotrope 200 par implantation par plasma, sur une profondeur précise correspondant à toute l'épaisseur de la couche diélectrique 30.

Ces paramètres sont en particulier :
- la pression régnant à l'intérieur de la chambre du réacteur plasma. De préférence, cette pression est inférieure à 100 milli Tor, ceci afin d'éviter une implantation isotrope ;
- la température sera de préférence inférieure à 100°C, afin de modifier efficacement la couche diélectrique 30.

Pour tous ces modes de réalisation, les conditions d'implantation peuvent être déterminées par simulation à l'aide d'un outil SRIM ou TRIM.

En plus des avantages mentionnés ci-dessus, l'implantation par plasma permet d'utiliser le même réacteur plasma pour la modification isotrope 100 et pour la modification anisotrope 200.

De préférence on effectuera la modification isotrope avec le même équipement que la modification anisotrope afin de simplifier le procédé et de réduire les couts.

Selon encore un autre mode de réalisation, lors de l'étape de modification isotrope ou lors de l'étape de modification anisotrope, et de préférence lors de chacune de ces étapes de modification, le plasma utilisé est formé à partir d'un gaz comprenant au moins un premier composant gazeux non carboné dont la dissociation génère lesdits ions légers et un deuxième composant gazeux comprenant au moins une espèce favorisant la dissociation du premier composant pour former lesdits ions légers, dans lequel le ratio de gaz entre le premier composant et le deuxième composant est compris entre 1 :19 et 19 :1.

De préférence ledit ratio est compris entre 1 :9 et 9 :1 et de préférence entre 1 :5 et 5 :1.

De préférence :
- le premier composant est choisi parmi l'hydrogène (H2), le nitrure de silicium (SiH4), le nitrure d'hydrogène (NH3) ou le bromure d'hydrogène (HBr).
- le deuxième composant est choisi parmi l'hélium (He), l'azote (N2), l'argon (Ar) ou le xénon (Xe).
- De préférence le débit du premier composant est compris entre 10 et 1000 sccm (centimètre cube par minute) et le débit du deuxième composant est de préférence compris entre 10 et 1000 sccm.

Avantageusement, le rôle du premier composant est de modifier, par bombardement ionique, la structure cristalline de la couche diélectrique afin de pouvoir, par la suite, différencier la couche diélectrique initiale de la couche diélectrique modifiée. Le problème est que si nous utilisons un plasma à base uniquement d'un seul composant, de l'hydrogène (H₂), par exemple, le risque est de ne pas modifier de façon uniforme la couche diélectrique dans son épaisseur. Cela entraîne un mauvais contrôle de la profondeur réelle jusqu'à laquelle la couche modifiée présente une sélectivité significativement améliorée. Dans ce cas, la profondeur de l'implantation ionique dans la couche diélectrique n'est pas équivalente à l'épaisseur de la couche diélectrique modifiée dont la sélectivité est significativement améliorée et qui sera gravée à la suite du bombardement.

L'ajout d'un deuxième composant agissant avantageusement comme un gaz de dissociation (tel que l'argon, l'hélium, le xénon, l'azote), permet de faciliter la dissociation du premier composant et par ce biais, de favoriser l'implantation dudit premier composant dissocié dans la couche diélectrique, sous forme d'ions légers. La dose implantée est donc plus élevée sans pour autant avoir besoin d'augmenter la profondeur maximale d'implantation.

Il est donc important de trouver un juste ratio entre la teneur en premier composant et en deuxième composant dans le plasma destiné à modifier la couche diélectrique. Avantageusement, le ratio de gaz entre le premier composant et le deuxième composant est supérieur à 1:19 et inférieur à 19 :1.

Ces implantations 100, 200 d'ions sont réalisées de préférence pleine plaque. Elles permettent de modifier la couche diélectrique 30 sans pour autant la pulvériser. Ainsi, il s'agit essentiellement d'une modification chimique, l'ajout d'ions dans cette couche 30 changeant la sélectivité à la gravure de cette couche 30. Ainsi, les portions modifiées 301, 302 de cette couche 30 se graveront beaucoup plus facilement que les portions 31, 32 non modifiées, les couches sous-jacentes 11, 50 ainsi que l'empilement de grille 20.

### Retrait sélectif des portions 301, 302 modifiées

Pour chacun des modes de réalisation mentionnés précédemment et basés sur une implantation d'ions, plusieurs variantes de réalisation pour le retrait sélectif des portions 301, 302 modifiées de la couche diélectrique 30 sont possibles.

Des chimies de gravure sèches ou humides mentionnées peuvent être utilisées.

Selon un mode de réalisation, l'étape de retrait des portions 301, 302 modifiées est effectuée par gravure humide sélective au matériau semi-conducteur de la couche active 11. Si le matériau semi-conducteur est du silicium, alors l'étape de retrait des portions 301, 302 modifiées est effectuée par gravure humide sélectivement au silicium (Si) et/ou à l'oxyde de silicium (SiO₂) des tranchées d'isolation 50.

De préférence, la gravure sélective au silicium est obtenue à l'aide d'une solution à base d'acide fluorhydrique (HF) ou à l'aide d'une solution à base d'acide phosphorique (H₃PO₄).

A titre d'exemple pour une couche diélectrique 30 en SiN, avec une solution à base d'acide fluorhydrique (HF), le rapport de vitesse de gravure entre SiN modifié et SiN est de l'ordre de 30; à titre d'exemple, le rapport de vitesse de gravure entre SiN modifié et SiO₂ est de l'ordre de 38.

Cela permet de retirer entièrement les portions 301, 302 modifiées sans consommer les portions non modifiée 31, 32 sur les flancs 24 et au pied de la grille 20 ; la couche active 11 ; les tranchées 50.

Les performances des transistors sont ainsi préservées.

Le matériau semi-conducteur peut également être du germanium (Ge) ou du silicium-germanium (SiGe).

Selon un mode de réalisation, particulièrement avantageux lorsque la couche diélectrique 30 est en un matériau pris parmi : un nitrure de silicium, SiC, SiCN, SiCBN, la gravure sélective des portions modifiées 301, 302 vis-à-vis des portions non modifiées comprend une gravure humide à base d'une solution comprenant de l'acide fluorhydrique (HF) diluée à x% en masse, avec x≤0.2 et présentant un pH inférieur ou égal à 1.5.

De préférence, le pH est inférieur ou égal à 1.3, de préférence inférieur ou égal à 1 et de préférence strictement inférieur à 1.

De préférence, x≤0.15 et de préférence x≤0.1. Selon un exemple, x est sensiblement égal à 0.1.

De préférence, la solution est obtenue par ajout d'au moins l'un parmi : acide chlorhydrique (HCl), acide sulfurique H₂SO₄, acide nitrique HNO₃.

De manière particulièrement surprenante cette gravure permet d'augmenter de manière très significative la sélectivité de la gravure de la couche diélectrique modifiée vis-à-vis des matériaux à base d'oxyde de silicium, désigné de manière générale SiOy dans la présente demande de brevet, avec y entier supérieur ou égal à 1.

Cette sélectivité améliorée est très avantageuse puisque bien souvent un masque dur sur le sommet 25 de la grille 20 ou une tranchée d'isolation 50, à base de SiOy, sont présents lors de l'étape de gravure.

Il s'ensuit que le masque dur 25 ou les tranchées d'isolation 50 ne sont pas altérés par la gravure des espaceurs. Ils peuvent donc pleinement jouer leurs rôles.

Habituellement des pH aussi acides ne sont pas utilisés car ils ne présentent pas d'intérêt dans le cadre de gravure classique de SiOy tel que le SiO2.

Par exemple, avec le procédé selon l'invention, on obtient une sélectivité de la gravure par rapport au dioxyde de silicium telle que pour une épaisseur e1 de nitrure modifié gravée, on ne grave dans le même temps qu'une épaisseur e1/33.7 de dioxyde de silicium.

Selon un autre mode de réalisation, l'étape de retrait est effectuée par gravure sèche sélective au matériau semiconducteur. De préférence, l'étape de retrait des portions 301, 302 modifiées, typiquement en nitrure de silicium, est effectuée par gravure sèche sélective au silicium (Si) et/ou à l'oxyde de silicium (SiO₂). Selon un mode de réalisation, la gravure sèche est effectuée dans un plasma formé dans une enceinte confinée à partir de trifluorure d'azote (NF₃) et d'ammoniac (NH₃).

Avantageusement, la gravure sèche comprend : une étape de gravure consistant en la formation de sels solides ; une étape de sublimation des espèces solides. Ce mode de réalisation permet d'obtenir une très bonne sélectivité de la gravure du nitrure modifié par rapport au nitrure non modifié et au matériau semi-conducteur. En particulier, cette sélectivité de la gravure est très supérieure (typiquement un facteur 10 au moins) à celle obtenue avec une solution de HF.

Selon un autre mode de réalisation, l'étape de retrait des portions 301, 302 modifiées vis-à-vis des portions 31, 32 non modifiées comprend une gravure sèche réalisée par mise en présence d'un mélange gazeux, de préférence uniquement gazeux, comprenant au moins un premier composant à base d'acide fluorhydrique (HF). L'acide fluorhydrique transforme en résidus non-volatiles, de préférence non-volatiles à température ambiante, les portions 301, 302 modifiées de la couche diélectrique 30.

Avantageusement, l'étape de retrait des portions 301, 302 comprend, uniquement après la gravure sèche, un retrait des résidus non-volatiles à température ambiante par un nettoyage humide ou un recuit thermique de sublimation.

Avantageusement, la gravure sèche consomme les portions 301, 302 modifiées de la couche diélectrique 30 préférentiellement aux portions 31, 32 non modifiées et à la couche active 11. Ainsi, le risque de consommation excessive de matériau semi-conducteur en surface de la couche active 11 est réduit, voire supprimé.

La reprise d'épitaxie destinée à former les S/D 60 bénéficie ainsi d'une surface de germination non dégradée.

La reprise d'épitaxie est optimisée. Les S/D facettés 60 présentent une qualité cristalline améliorée.

L'invention n'est pas limitée aux modes de réalisations précédemment décrits et s'étend à tous les modes de réalisation couverts par les revendications.

## Revendications

1. Procédé de réalisation sur une couche active (11) semi-conductrice d'au moins un transistor comprenant une grille, une source et un drain (60), lesdits source et drain (60) étant surélevés par rapport à la couche active (11) et présentant des facettes latérales (61) inclinées par rapport à une direction (Z) normale à la couche active (11), référencée direction Z, le procédé comprenant au moins les étapes suivantes :
- Fournir un empilement comprenant la couche active (11) s'étendant principalement selon un plan principal (XY) et un motif de grille (20), le motif de grille (20) présentant des flancs latéraux (24) s'étendant perpendiculairement à la couche active (11) ;
- Déposer sur le motif de grille (20) et la couche active (11) une couche (30) en un matériau diélectrique présentant une épaisseur e₃₀ et comprenant des portions, dites portions latérales (30L), recouvrant les flancs latéraux (24), et des portions, dites portions basales (30B), s'étendant principalement parallèlement audit plan principal (XY), les portions latérales (30L) étant sensiblement normales aux portions basales (30B);
- Réaliser une modification isotrope de ladite couche (30) sur une épaisseur e₃₀₁, de façon à obtenir une première portion (301) de couche modifiée comprenant un matériau diélectrique modifié, avec e₃₀₁ < e₃₀, la première portion (301) de couche modifiée étant conservée à l'issue de la modification isotrope, ladite modification isotrope étant réalisée par implantation d'ions,
- Avant ou après l'étape de réalisation d'une modification isotrope :
- Réaliser une modification anisotrope de ladite couche (30) sur une épaisseur e₃₀, selon la direction normale à la couche active (11), de façon à obtenir des deuxièmes portions (302) de couche modifiée comprenant le matériau diélectrique modifié en conservant des portions (31, 32) de couche non modifiée sur les flancs latéraux (24) du motif de grille (20) et sur la couche active (11) au pied du motif de grille (20), à l'aplomb des portions latérales (30L) couvrant les flancs (24) du motif de grille (20), les deuxièmes portions (302) de couche modifiée étant conservées à l'issue de la modification anisotrope, ladite modification anisotrope étant réalisée par implantation d'ions,
- Retirer les première (301) et deuxièmes (302) portions modifiées après les modifications isotrope et anisotrope en conservant les portions (31, 32) de couche non modifiée, par gravure sélective du matériau diélectrique modifié vis-à-vis du matériau diélectrique non modifié, de façon à former des espaceurs présentant une forme de L,
- Epitaxier les source et drain (60) au contact des espaceurs en forme de L, de façon à obtenir des source et drain surélevés par rapport à la couche active (11) et présentant des facettes latérales (61) inclinées par rapport à la direction Z.

2. Procédé selon la revendication précédente dans lequel la couche (30) en un matériau diélectrique est homogène et comprend uniquement ledit matériau diélectrique.

3. Procédé selon l'une quelconque des revendications précédentes dans lequel le dépôt de la couche (30) en un matériau diélectrique est un dépôt conforme, de sorte que les portions latérales (30L) et basales (30B) présentent sensiblement la même épaisseur e₃₀.

4. Procédé selon l'une quelconque des revendications précédentes dans lequel l'épaisseur e₃₀₀ est l'épaisseur de ladite couche (30) qui demeure non modifiée par ladite modification isotrope, avec e₃₀₀ = e₃₀ - eₑ₃₀₁, et dans lequel e₃₀₀ est telle que e₃₀₀ ≥ 2nm et de préférence e₃₀₀ ≥ 5nm.

5. Procédé selon la revendication précédente dans lequel l'épaisseur e₃₀₀ est telle que e₃₀₀ ≤ e₃₀ - 3nm.

6. Procédé selon l'une quelconque des revendications précédentes dans lequel l'épaisseur e₃₀ est comprise entre 5 nm et 30 nm, de préférence entre 7 nm et 12 nm, et l'épaisseur e₃₀₁ est comprise entre 3 nm et 6 nm.

7. Procédé selon l'une quelconque des revendications précédentes dans lequel le matériau diélectrique est choisi parmi le SiN, le SiCO, le SiC, le SiCN, le SiOCN, le SiCBN, le SiOCH, et le SiO2.

8. Procédé selon l'une quelconque des revendications précédentes dans lequel les modifications isotrope et anisotrope sont réalisées par implantation d'ions à partir d'un faisceau d'ions d'au moins une espèce parmi l'argon (Ar), le fluor (F), l'oxygène (O) et l'hydrogène (H).

9. Procédé selon la revendication précédente dans lequel la modification anisotrope est réalisée pour un faisceau d'ions principalement dirigé selon la direction normale au substrat lors de l'implantation.

10. Procédé selon l'une quelconque des revendications 1 à 7 dans lequel les modifications isotropes et anisotropes sont réalisées par implantation d'ions (100, 200) provenant d'un plasma, à partir d'au moins une espèce parmi H₂, He, HBr, et NH₃.

11. Procédé selon la revendication précédente dans lequel la modification isotrope est réalisée en maintenant une pression supérieure à 100 milli Torr lors de l'implantation (100).

12. Procédé selon l'une quelconque des deux revendications précédentes dans lequel la modification anisotrope est réalisée en maintenant une pression inférieure à 100 milli Torr lors de l'implantation (200).

13. Procédé selon l'une quelconque des revendications précédentes dans lequel la gravure sélective du matériau diélectrique modifié vis-à-vis du matériau diélectrique est une gravure humide à l'aide d'une solution à base d'acide fluorhydrique (HF) ou à l'aide d'une solution à base d'acide phosphorique (H₃PO₄).

## Patentansprüche

1. Verfahren zum Herstellen auf einer halbleitenden aktiven Schicht mindestens eines Transistors, der ein Gate, eine Source und einen Drain (60) umfasst, wobei die Source und der Drain (60) in Bezug auf die aktive Schicht (11) erhöht sind und seitliche Flächen (61) aufweisen, die in Bezug zu einer Richtung (Z) senkrecht zu der aktiven Schicht (11), Bezugsrichtung Z, geneigt sind, wobei das Verfahren mindestens die folgenden Schritte umfasst:
- Bereitstellen einer Stapelung, die die aktive Schicht (11) umfasst, die sich hauptsächlich gemäß einer Hauptebene (XY) erstreckt, und eines Gate-Pattern (20), wobei das Gate-Pattern (20) seitliche Flanken (24) aufweist, die sich senkrecht zu der aktiven Schicht (11) erstrecken;
- Abscheiden auf dem Gate-Pattern (20) und der aktiven Schicht (11) einer Schicht (30) aus einem dielektrischem Material, die eine Dicke e₃₀ aufweist und Abschnitte, als seitliche Abschnitte (30L) bezeichnet, umfasst, die die seitlichen Flanken (24) bedecken, und Abschnitte, als basale Abschnitte (30B) bezeichnet, die sich hauptsächlich parallel zu der Hauptebene (XY) erstrecken, wobei die seitlichen Abschnitte (30L) im Wesentlichen zu den basalen Abschnitten (30B) senkrecht stehen;
- Durchführen einer isotropen Modifikation der Schicht (30) auf einer Dicke e₃₀₁ derart, dass ein erster Abschnitt (301) modifizierter Schicht erhalten wird, der ein modifiziertes dielektrisches Material umfasst, mit e₃₀₁ < e₃₀, wobei der erste Abschnitt (301) modifizierter Schicht nach der isotropen Modifikation behalten wird, wobei die isotrope Modifikation durch Ionenimplantation durchgeführt wird,
- vor oder nach dem Ausführungsschritt einer isotropen Modifikation:
- Durchführen einer anisotropen Modifikation der Schicht (30) auf einer Dicke e₃₀ gemäß der Richtung senkrecht zu der aktiven Schicht (11) derart, dass zweite Abschnitte (302) modifizierter Schicht erhalten werden, die das modifizierte dielektrische Material umfassen unter Beibehalten von Abschnitten (31, 32) unmodifizierter Schicht auf den seitlichen Flanken (24) des Gate-Pattern (20) und auf der aktiven Schicht (11) am Fuß des Gate-Pattern (20) lotrecht zu den seitlichen Abschnitten (30L), die die Flanken (24) des Gate-Pattern (20) bedecken, wobei die zweiten Abschnitte (302) modifizierter Schicht nach der anisotropen Modifikation beibehalten werden, wobei die anisotrope Modifikation durch Implantation von Ionen durchgeführt wird,
- Entfernen des ersten (301) und der zweiten (302) modifizierten Abschnitts nach der isotropen und der anisotropen Modifikation unter Beibehalten der Abschnitte (31, 32) unmodifizierter Schicht durch selektives Ätzen des modifizierten dielektrischen Materials entgegengesetzt zu dem unmodifizierten dielektrischen Material derart, dass Abstandhalter, die eine L-Form aufweisen, gebildet werden,
- Epitaktisches Aufwachsen von Source und Drain (60) im Kontakt mit den L-förmigen Abstandshaltern derart, dass erhöhte Source und erhöhter Drain in Bezug auf die aktive Schicht (11) erhalten werden und seitliche Flächen (61) aufweisen, die in Bezug auf die Richtung Z geneigt sind.

2. Verfahren nach dem vorstehenden Anspruch, wobei die Schicht (30) aus dielektrischem Material homogen ist und nur das dielektrische Material umfasst.

3. Verfahren nach einem der vorstehenden Ansprüche, wobei das Abscheiden der Schicht (30) aus einem dielektrischen Material ein formangeglichenes Abscheiden derart ist, dass die seitlichen (30L) und basalen (30B) Abschnitte im Wesentlichen die gleiche Dicke e₃₀ aufweisen.

4. Verfahren nach einem der vorstehenden Ansprüche, wobei die Dicke e₃₀₀ die Dicke der Schicht (30) ist, die durch die isotrope Modifikation unmodifiziert bleibt, mit e₃₀₀ = e₃₀ - e₃₀₁, und wobei e₃₀₀ derart ist, dass e₃₀₀ ≥ 2 nm und bevorzugt e₃₀₀ ≥ 5 nm beträgt.

5. Verfahren nach dem vorstehenden Anspruch, wobei die Dicke e₃₀₀ derart ist, dass e₃₀₀ ≤ e₃₀ - 3 nm.

6. Verfahren nach einem der vorstehenden Ansprüche, wobei die Dicke e₃₀ zwischen 5 nm und 30 nm, bevorzugt zwischen 7 nm und 12 nm liegt, und die Dicke e₃₀₁ zwischen 3 nm und 6 nm liegt.

7. Verfahren nach einem der vorstehenden Ansprüche, wobei das dielektrische Material ausgewählt ist aus SiN, SiCO, SiC, SiCN, SiOCN, SiCBN, SiOCH und SiO2.

8. Verfahren nach einem der vorstehenden Ansprüche, wobei die isotrope und die anisotrope Modifikation durch Implantation von Ionen ausgehend von einem Ionenstrahl mindestens einer Art aus Argon (Ar), Fluor (F), Sauerstoff (O) und Wasserstoff (H) durchgeführt werden.

9. Verfahren nach dem vorstehenden Anspruch, wobei die anisotrope Modifikation für einen Ionenstrahl durchgeführt wird, der bei der Implantation hauptsächlich gemäß der Richtung senkrecht zu dem Substrat gelenkt wird.

10. Verfahren nach einem der Ansprüche 1 bis 7, wobei die isotropen und die anisotropen Modifikationen durch Implantation von Ionen (100, 200) durchgeführt werden, die aus einem Plasma stammen, mindestens ausgehend von einer Art aus H₂, He, Hbr und NH₃.

11. Verfahren nach dem vorstehenden Anspruch, wobei die isotrope Modifikation bei der Implantation (100) unter Halten eines Drucks größer als 100 Millitorr durchgeführt wird.

12. Verfahren nach einem der beiden vorstehenden Ansprüche, wobei die anisotropen Modifikationen bei der Implantation (200) unter Halten eines Drucks kleiner als 100 Millitorr durchgeführt wird.

13. Verfahren nach einem der vorstehenden Ansprüche, wobei das selektive Ätzen des modifizierten dielektrischen Materials dem dielektrischen Material entgegengesetzt ein Nassätzen mit Hilfe einer Lösung auf Flusssäurebasis (HF-Basis) oder mit Hilfe einer Lösung auf Phosphorsäurebasis (H₃PO₄) ist.

## Claims

1. Method for producing, on a semiconductive active layer (11) of at least one transistor comprising a gate, a source and a drain (60), said source and drain (60) being raised with respect to the active layer (11) and having lateral faces (61) tilted with respect to a direction (Z) normal to the active layer (11), referenced direction Z, the method comprising at least the following steps:
- Providing a stack comprising the active layer (11) extending mainly along a main plane (XY) and a gate pattern (20), the gate pattern (20) having lateral flanks (24) extending perpendicularly to the active layer (11);
- Depositing, on the gate pattern (20) and the active layer (11), a layer (30) made of a dielectric material having a thickness e₃₀ and comprising portions, called lateral portions (30L), covering the lateral flanks (24), and portions, called basal portions (30B), extending mainly parallel to said main plane (XY), the lateral portions (30L) being substantially normal to the basal portions (30B);
- Carrying out an isotropic modification of said layer (30) over a thickness e₃₀₁, so as to obtain a first portion (301) of modified layer comprising a modified dielectric material, with e₃₀₁ < e₃₀, the first portion (301) of modified layer being conserved from the isotropic modification, said isotropic modification being carried out by implantation of ions;
- Before or after the step of carrying out an isotropic modification:
- Carrying out an anisotropic modification of said layer (30) over a thickness e₃₀, along the direction normal to the active layer (11), so as to obtain second portions (302) of modified layer comprising the modified dielectric material by conserving portions (31, 32) of non-modified layer on the lateral flanks (24) of the gate pattern (20) and on the active layer (11) at the foot of the gate pattern, just under the lateral portions (30L) covering the flanks (24) of the gate pattern (20), the second portions (302) of modified layer being conserved from the anisotropic modification, said anisotropic modification being carried out by implantation of ions;
- Removing the first (301) and second (302) modified portions after the isotropic and anisotropic modifications by conserving the portions (31, 32) of non-modified layer by selective etching of the modified dielectric material opposite the non-modified dielectric material, so as to form spacers having an L-shape;
- Epitaxially growing the source and drain (60) in contact with the L-shaped spacers, so as to obtain the raised source and drain with respect to the active layer (11) and having lateral faces (61) tilted with respect to the direction Z.

2. Method according to the preceding claim, wherein the layer (30) made of a dielectric material is homogenous and only comprises said dielectric material.

3. Method according to any one of the preceding claims, wherein the deposition of the layer (30) made of a dielectric material is a conformal deposition, such that the lateral (30L) and the basal (30B) portions have substantially the same thickness e₃₀.

4. Method according to any one of the preceding claims, wherein the thickness e₃₀₀ is the thickness of said layer (30) which remains non-modified by said isotropic modification, with e₃₀₀ = e₃₀ - e₃₀₁, and wherein e₃₀₀ is such that e₃₀₀ ≥ 2nm, and preferably e₃₀₀ ≥ 5nm.

5. Method according to the preceding claim, wherein the thickness e₃₀₀ is such that e₃₀₀ ≤ e₃₀ - 3nm.

6. Method according to any one of the preceding claims, wherein the thickness e₃₀ is between 5nm and 30nm, preferably between 7nm and 12nm, and the thickness e₃₀₁ is between 3nm and 6nm.

7. Method according to any one of the preceding claims, wherein the dielectric material is selected from among SiN, SiCO, SiC, SiCN, SiOCN, SiCBN, SiOCH and SiO2.

8. Method according to any one of the preceding claims, wherein the isotropic and anisotropic modifications are carried out by implantation of ions from an ion beam of at least one type from among argon (Ar), fluorine (F), oxygen (O) and hydrogen (H).

9. Method according to the preceding claim, wherein the anisotropic modification is carried out for an ion beam mainly directed along the direction normal to the substrate during the implantation.

10. Method according to any one of claims 1 to 7, wherein the isotropic and anisotropic modifications are carried out by implantation of ions (100, 200) coming from a plasma, from at least one type from among H₂, He, HBr, and NH₃.

11. Method according to the preceding claim, wherein the isotropic modification is carried out by maintaining a pressure greater than 100 milli Torr during the implantation (100).

12. Method according to any one of the two preceding claims, wherein the anisotropic modification is carried out by maintaining a pressure less than 100 milli Torr during the implantation (200).

13. Method according to any one of the preceding claims, wherein the selective etching of the modified dielectric material opposite the dielectric material is a wet etching using a hydrofluoric (HF) acid-based solution or using a phosphoric (H₃PO₄) acid-based solution.
